# EUROPÄISCHE PATENTSCHRIFT

(11) **EP 0 649 723 B1**
(45) Veröffentlichungstag und Bekanntmachung des Hinweises auf die Patenterteilung: **22.03.2000**
(21) Anmeldenummer: 94116209.1
(22) Anmeldetag: 14.10.1994
(51) Int. Cl.: B29C 45/82, B29C 45/67

(54) **Hydraulisches Betriebssystem für Spritzgiessmaschinen**
Hydraulic actuation system for injection moulding machines
Système hydraulique de commande pour machines de moulage par injection

(30) Priorität: 18.10.1993 DE 4335328
(43) Veröffentlichungstag der Anmeldung: 26.04.1995
(73) Patentinhaber: Battenfeld GmbH, D-58540 Meinerzhagen (DE)
(72) Erfinder: Holzschuh, Johann, D-58540 Meinerzhagen (DE)
(74) Vertreter: Müller, Gerd, Dipl.-Ing.

(56) Entgegenhaltungen:
- EP-A- 0 097 275
- EP-A- 0 403 041
- EP-A- 0 464 286
- DE-A- 3 704 756
- DE-C- 4 335 403
- FR-A- 2 472 969
- US-A- 4 518 318
- KUNSTSTOFFE, Bd. 66, Nr. 2, 1976 MUNCHEN DE, Seiten 59-65, W. SPÄTH & H. WALTER 'Hydraulikelemente von Spritzgiessmaschinen'

## Beschreibung

Die Erfindung betrifft ein hydraulisches Betriebssystem für Spritzgießmaschinen mit einer druckspeicherlos arbeitenden Hydraulikpumpe und einer Mehrzahl von Hydraulikantrieben, die hiermit über ein Hydraulik-Leitungsnetz und Ventile in wählbarer Anzahl und Reihenfolge verbindbar sind, wobei die Hydraulikpumpe als Stetig- bzw. Konstantförderpumpe durch einen über einen vorgegebenen Drehzahlbereich in seiner Drehzahl stufenlos - oder aber zumindest vielstufig - regelbaren Elektromotor antreibbar ist. Ein solches Betriebssystem ist durch die EP-A-0 464 268 bekanntgeworden, wobei dort abweichend allerdings ein Druckspeichersystem vorhanden ist.

Der Einsatz von Druckspeichern beim Betrieb der Spritzzylinder einer Spritzgießmaschine ist weiterhin aus der FR-A-2 472 969 bekannt. Gleiches gilt für eine Spritzgießmaschine mit hydraulischen Verbrauchern gemäß der EP-A-0 403 041, indem an das geschlossene Hydrauliksystem ein Druckspeicher angeschlossen ist. Die hydraulischen Verbraucher sind dabei mit Pumpen verbunden, die von Wechselstrom-Servomotoren angetrieben werden.

Aus der DE-A-37 04 756 ist es bekannt, die Versorgung aller Verbraucher einer Heizungsanlage bei allen Betriebsbedingungen sicherzustellen, indem eine Umwälzpumpe zum Einstellen der Förderleistung durch einen stufenlos drehzahlregelbaren Elektromotor angetrieben wird. Bei einem ebenfalls das Vorhandensein eines Energiespeichers erfordernden hydrostatischen oder pneumatischen Antrieb für zu beschleunigende und abzubremsende Massen, insbesondere in Druck- und Spritzgießmaschinen, ist es durch die EP-A-0 097 275 bekanntgeworden, eine steuerbare Ventilanordnung vorzusehen, die je nach dem Vorzeichen der Änderung einer Volumenstromzunahme stoßartig bewegt wird.

Der diskontinuierliche Betrieb von Spritzgießmaschinen findet als Aufeinanderfolge von einzelnen Bewegungen statt, die von Hydraulikantrieben unterschiedlichster Größe bewerkstelligt werden. Als Hydraulikantriebe werden dabei Hydraulikzylinder und/oder Hydromotoren eingesetzt.

Der Betrieb von Spritzgießmaschinen macht es erforderlich, den Hydraulikstrom den jeweils auszuführenden Bewegungen anzupassen. Dabei ist es üblich, die Bewegung jedes einzelnen Hydraulikzylinders oder Hydromotors in der Weise zu beeinflussen, daß insbesondere in deren Anfangs- und Endphase eine Beschleunigung bzw. Verzögerung stattfindet, somit also eine im Ablauf ungleichförmige Bewegung hervorgebracht werden kann.

Die hydraulischen Betriebssysteme bekannter Art setzen zur Beeinflussung des an die Hydraulikzylinder oder Hydromotoren zu liefernden Hydraulikstromes unterschiedliche Methoden und Mittel ein. So ist es beispielsweise möglich, mit Mengenventilen im Nebenstrom-Pumpensystem zu arbeiten. Der Betrieb kann aber auch mit Mengenventilen im Hauptstrom bei Speichersystemen stattfinden. Bekannt ist schließlich aber auch die Benutzung von Pumpen mit veränderlichen Förderströmen.

Alle diese bekannten hydraulischen Betriebssysteme haben aber einen relativ schlechten Wirkungsgrad. Bei Pumpen mit veränderlichen Förderströmen kommt noch eine erhebliche Geräuschentwicklung hinzu, die in der Regel nur durch sekundäre Maßnahmen vermindert werden kann.

Ziel der Erfindung ist es, die Nachteile der bekannten hydraulischen Betriebssysteme für Spritzgießmaschinen zu vermeiden, also einen hohen Wirkungsgrad bei möglichst geringer Lärmentwicklung zu erhalten und zugleich die Betriebskosten zu minimieren.

Diese Aufgabe wird erfindungsgemäß mit den im unabhängigen Anspruch angegebenen Merkmalen gelöst.

Zweckmäßige Weiterbildungen der Erfindung sind Gegenstand der abhängigen Ansprüche.

Ein nach dem Erfindungsvorschlag ausgelegtes hydraulisches Betriebssystem hat den besonderen Vorteil, daß je Zeiteinheit stets nur die Menge an Hydraulikflüssigkeit in das Betriebssystem eingespeist wird, welche für die einwandfreie Versorgung der jeweils im Betrieb stehenden Hydraulikantriebe nötig ist. Das hydraulische Betriebssystem hat daher einen guten Wirkungsgrad und spart Betriebskosten, weil Verlustströme an Hydraulikflüssigkeit nicht gefördert werden müssen. Mit der Maßnahme, daß der Elektromotor von einer einen integrierten, über einen programmierbaren, je Zeiteinheit auf die Drehzahlregelung wirkenden Rampenbildner aufweisenden Steuerung ansteuerbar ist, lassen sich die Anfangs- und Endphase der Bewegung jedes einzelnen Hydraulikantriebes vorteilhaft beeinflussen.

Die Drehzahlregelung des Elektromotors kann bspw. als Zweigrößenregelung über eine Druck- und Durchflußregelung stattfinden, wobei zwei vollständige Regelkreise durch die gekoppelte Regelstrecke miteinander verbunden sind, sich also gegenseitig beeinflussen können.

Eine Weiterbildung der Erfindung sieht weiterhin vor, daß als Stetig- bzw. Konstant-Förderpumpe eine Innenzahnradpumpe vorgesehen wird.

In weiterer Ausgestaltung der Erfindung hat es sich als besonders vorteilhaft erwiesen, wenn als Elektromotor ein vektorgeregelter Drehstromkurzschlußläufermotor eingesetzt wird. In diesem Falle kann der Elektromotor wahlweise mit oder ohne Drehzahlgeber ausgeführt werden, wobei die letztgenannte Betriebsweise aus Kostengründen vorzuziehen ist.

Nach einer Weiterbildung der Erfindung kann aber auch ein frequenzgeregelter Drehstromkurzschlußläufermotor oder aber ein Drehstromservomotor zum Antrieb der Hydraulikpumpe eingesetzt werden.

Wesentlich in allen Fällen ist aber, daß die für die einzelnen Betriebsbewegungen der Spritzgießmaschine einschließlich Beschleunigung und Verzögerung benötigten, unterschiedlichen Hydraulik-Förderströme dadurch gebildet werden, daß der Elektromotor die Hydraulikpumpe unterschiedlich schnell dreht und dabei insbesondere für sanfte Übergänge von einer Drehzahl auf die andere sorgt.

Als wichtige Weiterbildungsmaßnahme der Erfindung hat sich herausgestellt, daß der Stetig- bzw. Konstant-Förderpumpe ein elektrisch ansteuerbares Druckbegrenzungs- und -entlastungsventil bzw. ein Proportionaldruckbegrenzungsventil zugeordnet wird, so daß neben einer optimalen Verbrauchsmengenregelung auch eine optimale Verbrauchsdruckregelung sichergestellt werden kann.

In baulicher Hinsicht hat sich besonders der Erfindungsvorschlag bewährt, die Stetig- bzw. Konstant-Förderpumpe unmittelbar an den Elektromotor anzuflanschen oder mit diesem über einen Pumpenträger zu verbinden.

Im praktischen Einsatz bewährt hat sich ein hydraulisches Betriebssystem für Spritzgießmaschinen, welches einen Schließzylinder, einen Einbauhöhenverstellzylinder und einen Auswerferzylinder an der Werkzeug-Schließeinheit sowie den Schneckenantrieb, einen Spritzzylinder und mindestens einen Düsenandruckzylinder des Spritzaggregates umfaßt, welche jeweils durch ein eigenes Wegeventil ansteuerbar sind.

Als vorteilhaft hat sich im Rahmen der Erfindung auch erwiesen, wenn der Elektromotor für die Hydraulikpumpe über einen Drehzahlbereich zwischen 10 und 2500 U/min, vorzugsweise zwischen 120 und 1800 U/min regelbar ist. Dabei kann die Drehzahlregelung des Elektromotors einer Sollwert/Istwert-Steuerung unterliegen, die gegebenenfalls wiederum über Initiatoren bzw. Fühler und/oder Weggeber an den Hydraulikantrieben und/oder deren Wegeventilen beeinflußbar ist.

Das Druckbegrenzungs- und -entlastungsventil bzw. das Proportionaldruckbegrenzungsventil kann unmittelbar an der Hydraulikpumpe angebracht sein, weil sich hierdurch die Güte des Druckregelkreises beträchtlich erhöht. Wegen des guten Wirkungsgrades des hydraulischen Betriebssystems ist - wenn überhaupt - nur eine minimale Kühlung der Hydraulikflüssigkeit nötig, so daß sich auch hierdurch Betriebskosteneinsparungen ergeben.

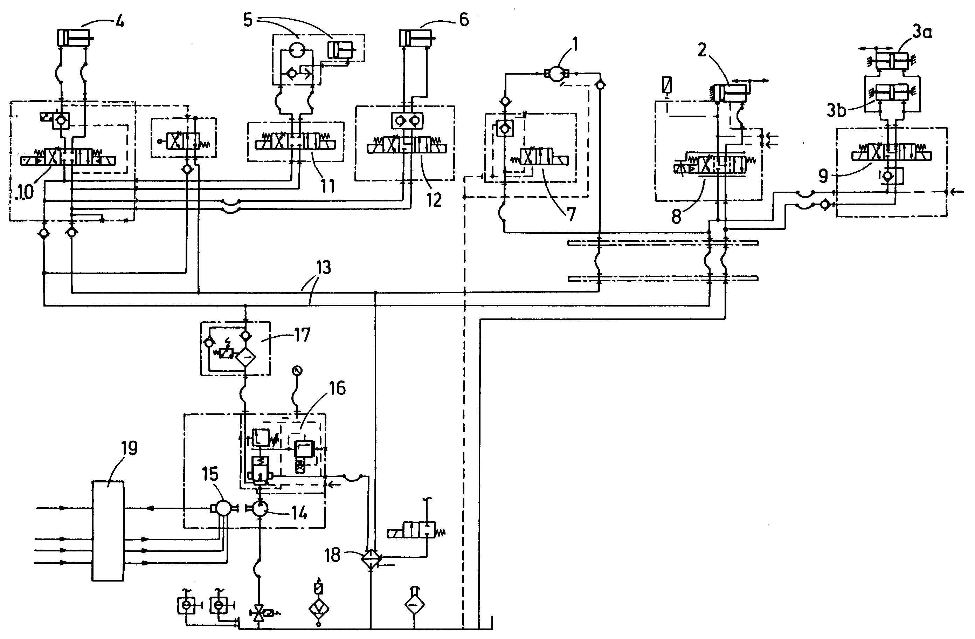

In einer einzigen Zeichnungsfigur ist ein Ausführungsbeispiel eines hydraulischen Betriebssystems für Spritzgießmaschinen schematisch dargestellt.

Die selbst aus der Zeichnung nicht ersichtliche Spritzgießmaschine weist einen Schneckenantriebs-Hydromotor 1, einen Spritzzylinder 2 sowie mindestens einen Düsenandruckzylinder 3a und 3b auf.

Die zur Spritzgießmaschine gehörende und ebenfalls nicht gezeigte Werkzeug-Schließeinheit ist mit einem Schließzylinder 4, einer Einbauhöhenverstellung 5 und einem Auswerferzylinder 6 ausgestattet.

Alle diese Antriebskomponenten 1, 2, 3a, 3b, 4, 5 und 6 sind als Hydraulikantriebe ausgelegt, die jeweils über Wegeventile 7, 8, 9, 10, 11 und 12 mit einem Hydraulik-Leitungsnetz 13 Verbindung haben.

Zu dem hydraulischen Betriebssystem für die Spritzgießmaschine gehört darüber hinaus noch eine Hydraulikpumpe 14, die mit einem Elektromotor 15 gekuppelt ist. Die Druckseite der Hydraulikpumpe 14 arbeitet auf ein elektrisch ansteuerbares Druckbegrenzungs- und -entlastungsventil 16, das als Proportionaldruckbegrenzungsventil ausgelegt ist und dabei die Hydraulikflüssigkeit über ein Ölfilter 17 in das Hydraulik-Leitungsnetz 13 einspeist. Auch ein Ölkühler 18 ist in das Hydraulik-Leitungsnetz 13 im Bereich der Hydraulikpumpe 14 und des Proportionaldruckbegrenzungsventils 16 eingeschaltet. Schließlich ist das hydraulische Betriebssystem auch noch mit einer programmierbaren Steuerung 19 ausgestattet, die auch je einen Sollwert- und Istwert-Eingang aufweist sowie für eine Drehzahlregelung des Elektromotors 15 und damit auch der Hydraulikpumpe 14 ausgelegt ist.

Als Hydraulikpumpe 14 ist eine Stetig- bzw. Konstant-Förderpumpe eingesetzt, die in besonders vorteilhafter Weise als Innenzahnradpumpe arbeitet. Sie ist von ihrer Größe her so bemessen, daß sie mindestens ein der maximalen Verbrauchsmenge sämtlicher Hydraulikantriebe 1 bis 6 entsprechendes Förder(strom)-Volumen und/oder auch einen maximalen Förderdruck hervorbringen kann.

Bei dem den Antrieb der Hydraulikpumpe 14 bewerkstelligenden Elektromotor 15 handelt es sich um einen über einen vorgegebenen Drehzahlbereich in seiner Drehzahl stufenlos - oder aber zumindest vielstufig - regelbaren Elektromotor. Dieser kann für einen Drehzahlbereich zwischen 10 und 2500 U/min ausgelegt sein und sollte vorzugsweise im Bereich zwischen 120 und 1800 U/min betrieben werden. Bei vielstufiger Betriebsweise sollte der Elektromotor 15 vorzugsweise über 99 Drehzahlstufen hinweg betriebsfähig sein.

Besonders bewährt hat sich für den Antrieb der Hydraulikpumpe 14 ein vektorgeregelter Drehstromkurzschlußläufermotor 15. Für den gleichen Zweck kann jedoch auch ein frequenzgeregelter Drehstromkurzschlußläufermotor 15 eingesetztwerden. Schließlich besteht aber auch noch die Möglichkeit, die Hydraulikpumpe 14 durch einen Drehstromservomotor 15 zu betreiben.

Das der Hydraulikpumpe 14 unmittelbar nachgeschaltete Proportionaldruckbegrenzungsventil 16 läßt sich, ebenso wie die Antriebsdrehzahl des Elektromotors 15, durch die programmierbare Steuerung 19 beeinflussen. Dabei ist vorgesehen, daß der Elektromotor 15 von der Steuerung 19 aus über einen programmierbaren und je Zeiteinheit auf die Drehzahlregelung wirkenden Rampenbildner ansteuerbar ist. Der in die Steuerung 19 integrierte Rampenbildner sorgt dabei nicht nur für sanfte Übergänge von einer Drehzahlstufe auf eine andere, sondern ist auch in der Lage, die Anfangs- und Endphase jeder Bewegung eines der Hydraulikantriebe 1 bis 6 vorteilhaft zu beeinflussen.

Selbstverständlich ist es denkbar, über den Rampenbildner der programmierbaren Steuerung 19 auch das Proportionaldruckbegrenzungsventil 16 anzusteuern, um die Druckregelung für die in das Hydraulik-Leitungsnetz 13 eingespeiste Hydraulikflüssigkeit zu optimieren. Andererseits ist es aber auch möglich, an den verschiedenen Hydraulikantrieben 1 bis 6 und/oder an den ihnen zugeordneten Wegeventilen 7 bis 12 noch Initiatoren bzw. Fühler und/oder Weggeber vorzusehen, mit denen sich wiederum Einfluß auf die Steuerung 19 für die Drehzahlregelung des Elektromotors 15 nehmen läßt.

Die vorstehend beschriebene Auslegung des hydraulischen Betriebssystems für Spritzgießmaschinen macht es in vorteilhafter Weise möglich, je Zeiteinheit in das Hydraulik-Leitungsnetz 13 stets nur diejenige Menge an Hydraulikflüssigkeit mit demjenigen Druckniveau einzuspeisen, welches augenblicklich für den Betrieb der jeweils in Bewegung zu setzenden und zu haltenden Hydraulikantriebe benötigt wird. Verlustmengen an Hydraulikflüssigkeit müssen also nicht gefördert werden, so daß das gesamte Betriebssystem mit gutem Wirkungsgrad, zugleich aber gerauscharm gefahren werden kann und dabei mit minimalen Betriebskosten auskommt. Eine besonders kostengünstige Betriebsweise ergibt sich, wenn der Elektromotor 15 für die Hydraulikpumpe 14 mit vielstufiger Drehzahlregelung, bspw. 99-stufiger Drehzahlregelung betrieben werden kann, weil hierfür nur ein geringer Steuerungsaufwand in der Elektronik nötig ist.

Es wurde bereits weiter oben erwähnt, daß durch Anordnung des Proportionaldruckbegrenzungsventils 16 unmittelbar an der Hydraulikpumpe die Güte des Druckregelkreises besonders vorteilhaft beeinflußt werden kann.

Baulich hat es sich aus Kostengründen besonders bewährt, wenn die Hydraulikpumpe 14 unmittelbar an den Elektromotor 15 angeflanscht wird.

Abschließend sei hier noch erwähnt, daß die Hydraulikantriebe 1 bis 6 und die Wegeventile 7 bis 12 des in der Zeichnung dargestellten hydraulischen Betriebssystems nur beispielhaft wiedergegeben sind. Je nach Bedarf können sie jedoch eine andere als die aus der Zeichnung ersichtliche Auslegung haben. Wesentlich für das hydraulische Betriebssystem ist jedoch, daß die für die Bewegung der verschiedenen Hydraulikantriebe 1 bis 6 benötigten Förder(strom)-Volumen und/oder -drücke praktisch ausschließlich dadurch gebildet werden, daß der Elektromotor 15 die als Stetig- bzw. Konstantförderpumpe ausgelegte Hydraulikpumpe 14 unterschiedlich dreht und daß dabei die Drehzahlregelung dieses Elektromotors 15 besonders für sanfte Übergänge von einer Drehzahl auf eine andere sorgt.

Die einzelnen Hydraulikantriebe 1 bis 6 der Spritzgießmaschine sind in der Regel nicht nur von ihrer Bau- und Leistungsgröße her mit einer völlig unterschiedlichen Auslegung im Einsatz. Vielmehr werden sie auch noch mit sehr verschiedenen Arbeitsdruckbereichen betrieben.

Hieran ist das hydraulische Betriebssystem in seiner vorstehend beschriebenen Ausstattung jederzeit problemlos anpaßbar.

## Patentansprüche

1. Hydraulisches Betriebssystem für Spritzgießmaschinen mit einer druckspeicherlos arbeitenden Hydraulikpumpe (14) und einer Mehrzahl von Hydraulikantrieben (1 bis 6), die hiermit über ein Hydraulik-Leitungsnetz und Ventile (9 bis 12) in wählbarer Anzahl und Reihenfolge verbindbar sind, wobei die Hydraulikpumpe (14) als Stetig - bzw. Konstantförderpumpe mit einem mindestens der maximalen Verbrauchsmenge aller Hydraukikantriebe (1 bis 6) entsprechenden Förderstrom- Volumen und/oder -druck ausgelegt ist und durch einen über einen vorgegebenen Drehzahlbereich in seiner Drehzahl stufenlos - oder aber zumindest vielstufig- regelbaren Elektromotor (15) antreibbar ist, dessen maximale Antriebsdrehzahl das Förderstrom-Volumen und/oder den Förderdruck an die maximale Verbrauchsmenge und/oder den maximalen Verbrauchsdruck aller Hydraulikantriebe (1 bis 6) anpaßt, indem die Drehzahl für den Elektromotor (15) proportional der Verbrauchsmenge und/oder dem Verbrauchsdruck der jeweils in Betrieb gesetzten Hydraulikantriebe (1 bis 6) regelbar ist, wobei der Elektromotor (15) von einer einen integrierten, über einen programmierbaren und je Zeiteinheit auf die Drehzahl wirkenden Rampenbildner aufweisenden Steuerung (19) ansteuerbar ist.

2. Hydraulisches Betriebssystem nach Anspruch 1, wobei
als Stetig- bzw. Konstantförderpumpe (14) eine Innenzahnradpumpe vorgesehen ist.

3. Hydraulisches Betriebssystem nach einem der Ansprüche 1 und 2, wobei
als Elektromotor (15) ein vektorgeregelter Drehstromkurzschlußläufermotor vorgesehen ist.

4. Hydraulisches Betriebssystem nach einem der Ansprüche 1 und 2, wobei
als Elektromotor (15) ein frequenzgeregelter Drehstromkurzschlußläufermotor vorgesehen ist.

5. Hydraulisches Betriebssystem nach einem der Ansprüche 1 und 2, wobei
als Elektromotor (15) ein Drehstromservomotor vorgesehen ist.

6. Hydraulisches Betriebssystem nach einem der Ansprüche 1 bis 5, wobei
der Stetig- bzw. Konstant-Förderpumpe (14) ein elektrisch ansteuerbares Druckbegrenzungs- und -entlastungsventil bzw. Proportionaldruckbegrenzungsventil (16) zugeordnet ist.

7. Hydraulisches Betriebssystem nach einem der Ansprüche 1 bis 6, wobei
über den Rampenbildner auch das Druckbegrenzungs- und - entlastungsventil bzw. Proportionaldruckbegrenzungsventil (16) ansteuerbar ist.

8. Hydraulisches Betriebssystem nach einem der Ansprüche 1 bis 7, wobei
die Stetig- bzw. Konstant-Förderpumpe (14) unmittelbar an den Elektromotor (15) angeflanscht oder mit diesem über einen Pumpenträger verbunden ist.

9. Hydraulisches Betriebssystem nach einem der Ansprüche 1 bis 8, wobei
es einen Schließzylinder (4), einen Einbauhöhenverstellmotor (5) und einen Auswerferzylinder (6) an der WerkzeugSchließeinheit sowie den Schneckenantriebs-Hydromotor (1), einen Spritzzylinder (2) und mindestens einen Düsenandruckzylinder (3a und 3b) des Spritzaggregates umfaßt, welche jeweils durch ein eigenes Wegeventil (10, 11, 12 bzw. 7, 8, 9) ansteuerbar sind.

10. Hydraulisches Betriebssystem nach einem der Ansprüche 1 bis 9, wobei
der Elektromotor (15) über einen Drehzahlbereich zwischen 10 und 2500 U/min, vorzugsweise zwischen 120 und 1800 U/min regelbar ist.

11. Hydraulisches Betriebssystem nach einem der Ansprüche 1 bis 10, wobei
die Drehzahlregelung des Elektromotors (15) einer Sollwert/Istwert-Steuerung (19) unterliegt, die gegebenenfalls wiederum durch Initiatoren bzw. Fühler und/oder Weggeber an den Hydraulikantrieben (1 - 6) und/oder deren Wegeventilen (7 - 12) beeinflußbar ist.

## Claims

1. Hydraulic operating system for injection moulding machines with a hydraulic pump (14), which operates without pressure storage, and a plurality of hydraulic drives (1 to 6), which are connectible therewith in selectable number and sequence by way of a hydraulic duct mains and valves (9 to 12), wherein the hydraulic pump (14) is designed as a continuously or constantly conveying pump with a conveying flow, volume and/or pressure, which corresponds with at least the maximum consumption amount of all hydraulic drives (1 to 6), and is drivable by an electric motor (15), which above a preset rotational speed range can be regulated in its rotational speed steplessly or, however, at least in a plurality of steps and the maximum drive rotational speed of which matches the conveying flow, volume and/or pressure to the maximum consumption quantity and/or the maximum consumption pressure of all hydraulic drives (1 to 6), in that the rotational speed for the electric motor (15) can be regulated proportionally to the consumption quantity and/or the consumption pressure of the respective hydraulic drives (1 to 6) set in operation, wherein the electric motor (15) is controllable in drive by an integrated control (19) comprising a programmable ramp former acting on the rotational speed per time unit.

2. Hydraulic operating system according to claim 1, wherein an internally toothed impeller pump is provided as the continuously or constantly conveying pump (14).

3. Hydraulic operating system according to one of claims 1 and 2, wherein a vector-regulated, three-phase squirrel cage motor is provided as the electric motor (15).

4. Hydraulic operating system according to one of claims 1 and 2, wherein a frequency-regulated, three-phase squirrel cage motor is provided as the electric motor (15).

5. Hydraulic operating system according to one of claims 1 and 2, wherein a three-phase servomotor is provided as the electric motor (15).

6. Hydraulic operating system according to one of claims 1 to 5, wherein an electrically controllable pressure limiting and relief valve or proportional pressure-limiting valve (16) is associated with the continuously or constantly conveying pump (14).

7. Hydraulic operating system according to one of claims 1 to 6, wherein the pressure limiting and relief valve or proportional pressure-limiting valve (16) is also controllable by way of the ramp former.

8. Hydraulic operating system according to one of claims 1 to 7, wherein the continuously or constantly conveying pump (14) is flange-connected directly with the electric motor (15) or connected with this by way of a pump carrier.

9. Hydraulic operating system according to one of claims 1 to 8, wherein it comprises a closing cylinder (4), an installation height adjusting motor (5) and an ejector cylinder (6) at the tool closing unit as well as the worm drive hydraulic motor (1), an injection cylinder (2) and at least one nozzle pressing-on cylinder (3a and 3b) of the injection unit, which are each controllable by an individual path valve (10, 11, 12 or 7, 8, 9).

10. Hydraulic operating system according to one of claims 1 to 9, wherein the electric motor (15) is regulable above a rotational speed range between 10 and 2500 rpm, preferably between 120 and 1800 rpm.

11. Hydraulic operating system according to one of claims 1 to 10, wherein the rotational speed regulation of the electric motor (15) is subject to a target and actual value control (19), which in a given case can in turn be influenced by initiators or sensors and/or travel transmitters at the hydraulic drives (1 to 6) and/or the path valves (7 to 12) thereof.

## Revendications

1. Système hydraulique de commande pour machines de moulage par injection, présentant une pompe hydraulique (14) fonctionnant sans accumulateur hydraulique et plusieurs dispositifs d'entraînement hydrauliques (1 à 6) qui peuvent être reliés à ladite pompe via un réseau de conduites hydrauliques et de soupapes (9 à 12) en un nombre et dans un ordre au choix, la pompe hydraulique (14) étant exécutée comme une pompe d'alimentation continue ou constante avec un courant volumique et/ou une pression d'alimentation correspondant au moins à la quantité de consommation maximale de tous les dispositifs d'entraînement hydrauliques et pouvant être entraînée par un moteur électrique (15) dont la vitesse peut être réglée dans une plage prédéfinie du nombre de tours d'entraînement de manière continue ou du moins à un grand nombre de vitesses, dont la vitesse d'entraînement maximale adapte le courant volumique d'alimentation et/ou la pression d'alimentation à la quantité de consommation maximale et/ou la pression de consommation maximale de tous les dispositifs d'entraînement hydrauliques (1 à 6), dans lequel la vitesse du moteur électrique (15) peut être réglée proportionnellement à la quantité de consommation et/ou la pression de consommation des dispositifs d'entraînement hydrauliques (1 à 6) en fonctionnement, le moteur électrique (15) pouvant être commandé par un dispositif de commande (19) présentant un dispositif d'établissement d'une rampe intégré, pouvant être programmé et agissant par unité de temps sur le nombre de tours.

2. Système hydraulique de commande selon la revendication 1, dans lequel on a prévu comme pompe d'alimentation continue ou constante (14) une pompe à roue à denture intérieure.

3. Système hydraulique de commande selon une quelconque des revendications 1 et 2, dans lequel on a prévu comme moteur électrique (15) un moteur triphasé à rotor en court-circuit régulé par vecteur.

4. Système hydraulique de commande selon une quelconque des revendications 1 et 2, dans lequel on a prévu comme moteur électrique (15) un moteur triphasé à rotor en court-circuit régulé par fréquence.

5. Système hydraulique de commande selon une quelconque des revendications 1 et 2, dans lequel on a prévu comme moteur électrique (15) un servomoteur triphasé.

6. Système hydraulique de commande selon une quelconque des revendications 1 à 5, dans lequel la pompe d'alimentation constante ou continue (14) est associée à une soupape de limitation de la pression et d'évacuation de la pression ou une soupape de limitation de la pression proportionnelle (16) pouvant être commandée électriquement.

7. Système hydraulique de commande selon une quelconque des revendications 1 à 6, dans lequel le dispositif d'établissement de la rampe commande également la soupape de limitation de la pression et d'évacuation de la pression ou la soupape de limitation de la pression proportionnelle (16).

8. Système hydraulique de commande selon une quelconque des revendications 1 à 7, dans lequel la pompe d'alimentation continue ou constante (14) est reliée directement via une bride au moteur électrique (15) ou est reliée à celui-ci via un support de pompe.

9. Système hydraulique de commande selon une quelconque des revendications 1 à 8, comprenant un cylindre de fermeture (4), un moteur incorporé de réglage de la hauteur (5) et un cylindre d'évacuation (6) sur l'unité de fermeture de l'outil ainsi que le moteur hydraulique d'entraînement de la vis sans fin (1), un cylindre d'injection (2) et au moins un cylindre de mise sous pression des gicleurs (3a et 3b) de l'appareil de moulage par injection, chacun pouvant être commandé par un distributeur (10, 11, 12 ou 7, 8, 9) propre.

10. Système hydraulique de commande selon une quelconque des revendications 1 à 9, dans lequel le moteur électrique (15) peut être réglé dans une plage de vitesses comprise entre 10 et 2500 tpm, de préférence entre 120 et 1800 tpm.

11. Système hydraulique de commande selon une quelconque des revendications 1 à 10, dans lequel la régulation de la vitesse du moteur électrique (15) est soumise à une commande par valeur de consigne/ valeur instantanée, qui peut être influencée par des initiateurs ou des sondes et/ou des capteurs sur les dispositifs d'entraînement hydrauliques 1-6) et/ou les distributeurs (7-12).
